# NEUE EUROPÄISCHE PATENTSCHRIFT

(11) **EP 1 175 600 B2**
(45) Veröffentlichungstag und Bekanntmachung des Hinweises auf die Entscheidung über den Einspruch: **27.10.2010**
(45) Hinweis auf die Patenterteilung: 28.02.2007
(21) Anmeldenummer: 00929380.4
(22) Anmeldetag: 18.04.2000
(51) Int. Cl.: G01D 5/347, H01L 31/12

(54) **INTEGRIERTER OPTOELEKTRONISCHER DÜNNSCHICHTSENSOR**
INTEGRATED OPTOELECTRONIC THIN-FILM SENSOR
CAPTEUR A COUCHE MINCE, OPTOELECTRONIQUE, INTEGRE

(30) Priorität: 21.04.1999 DE 19917950
(43) Veröffentlichungstag der Anmeldung: 30.01.2002
(60) Teilanmeldung: 07003460.8
(73) Patentinhaber: Dr. Johannes Heidenhain GmbH, 83292 Traunreut (DE)
(72) Erfinder: SPECKBACHER, Peter, D-84558 Kirchweidach (DE); MICHEL, Dieter, D-83278 Traunstein (DE)
(86) Internationale Anmeldenummer: PCT/EP2000/003509
(87) Internationale Veröffentlichungsnummer: WO 2000/063654

(56) Entgegenhaltungen:
- EP-A- 0 543 513
- EP-A- 0 630 057
- EP-A- 1 014 034
- DE-A- 19 618 593
- DE-A1- 3 201 185
- DE-A1- 19 701 941
- DE-C- 19 524 725
- GB-A- 2 315 594
- PATENT ABSTRACTS OF JAPAN vol. 018, no. 673 (E-1647), 19. Dezember 1994 (1994-12-19) -& JP 06 268254 A (TOSHIBA CORP), 22. September 1994 (1994-09-22)

## Beschreibung

Die Erfindung betrifft einen integrierten optoelektronischen Dünnschichtsensor für ein Messsystem nach Anspruch 1.

Aus der GB 1,504,691 und der korrespondierenden DE 25 11 350 A1 ist ein Messsystem bekannt, bei dem die Verschiebung einer ersten Baugruppe relativ zu einer zweiten Baugruppe ermittelt wird. Dafür sind zwei Gitter vorgesehen, die zueinander einen konstanten Abstand aufweisen und von denen je eines an einer Baugruppe befestigt wird. Wird das zweite Gitter mit divergentem Licht einer Lichtquelle bestrahlt, erzeugt das erste Gitter ein periodisches Abbild des zweiten Gitters, wobei sich dieses Abbild bewegt, wenn zwischen den beiden Baugruppen eine relative Bewegung vorliegt. Weiterhin sind Fotodetektoren vorgesehen, die eine periodische Struktur aufweisen und fest mit der zweiten Baugruppe verbunden sind. Dabei ist das erste ein reflektierendes Gitter und das zweite Gitter und die Fotodetektoren liegen im wesentlichen in einer Ebene. Die Lichtquelle und das zweite Gitter können auch durch eine strukturierte Lichtquelle ersetzt werden, die das gleiche Abbild wie eine herkömmliche Lichtquelle und ein Gitter erzeugen. Die Struktur der Fotodetektoren interagiert mit dem Abbild derart, dass eine periodische Änderung des Ausgabesignals der Fotodetektoren auftritt, wenn zwischen erster und zweiter Baugruppe eine Relativbewegung vorliegt.

Dabei ist von Nachteil, dass die einzelnen Baugruppen diskret und separat realisiert werden. Dadurch ist ein relativ großer Einbauraum für die gesamte Anordnung erforderlich.

Auch die DE 19524725 C1 zeigt ein Positionsmesssystem, bei dem die Bestandteile Lichtquelle, Photodetektor und Folgelektronik diskret aufgebaut sind. Diese Bestandteile sind zusammen mit einem Gitter auf einem transparenten Träger angeordnet.

Aus der DE 197 01 941 A1 ist bekannt, dass auf der einem Maßstab zugewandten Seite eines lichtdurchlässigen Trägers ein Abtastgitter angeordnet ist. Das Abtastgitter wird von einer Lichtquelle derart bestrahlt, dass ein Abbild des Gitters auf den Maßstab projiziert wird. Auf dem Maßstab befindet sich ein zweites Gitter, welches das Abbild auf einen strukturierten Fotodetektor reflektiert. Dabei sind der lichtdurchlässige Träger für das erste Gitter mit dem Halbleitermaterial, in dem der strukturierte Fotodetektor realisiert ist, miteinander derart verbunden, dass Abtastgitter und Fotodetektor ausschließlich in Messrichtung zueinander versetzt sind, vom Maßstab aber die gleiche Entfernung aufweisen. In einer zweiten Ausführungsform der DE 197 01 941 A1 ist das Abtastgitter auf der dem Maßstab abgewandten Seite des lichtdurchlässigen Trägers angeordnet. Auf der gleichen Seite wie das Abtastgitter ist ein Optochip auf dem gleichen lichtdurchlässigen Träger angeordnet, welches den Fotodetektor beinhaltet. Auch durch diese Anordnungen wird erreicht, dass Abtastgitter und strukturierter Fotodetektor ungefähr den gleichen Abstand vom Maßstab aufweisen.

Bei der ersten Ausführungsform besteht der Nachteil, dass der lichtdurchlässige Träger, auf dem das Abtastgitter aufgebracht ist, mit dem Halbleitermaterial, in dem der strukturierte Fotodetektor realisiert ist, verbunden werden muss. Diese Verbindung muss sehr genau erfolgen, so dass die Struktur des Fotodetektors parallel zum Gitter ausgerichtet ist und Struktur und Gitter den gleichen Abstand vom Maßstab aufweisen. Diese exakte Verbindung zwischen Träger und Halbleitermaterial ist daher sehr schwierig zu realisieren. Weiterhin weist die zweite Ausführungsform den Nachteil auf, dass ein Optochip auf dem lichtdurchlässigen Träger befestigt werden muss. Durch die Befestigung in Chip-on-Glass Technologie entsteht zwangsläufig ein Abstand zwischen dem Optochip und dem Träger, wodurch der Abstand zwischen Sendegitter und Maßstab sowie zwischen Fotodetektor und Maßstab wesentlich voneinander abweichen, was zu einer deutlichen Verschlechterung der optischen Eigenschaften der Anordnung führt.

Aus der DE 40 91 517 T1 ist bekannt, einen Sensor für ein Messsystem aus einem einzigen Block aus Halbleitermaterial zu realisieren. Dabei sind auf der Oberfläche einer flächig ausgestalteten Leuchtdiode als Gitterlinien ausgestaltete Fotoelemente vorgesehen, durch welche die Leuchtdiode nicht hindurchstrahlen kann. Dadurch entsteht ein strukturierter Fotodetektor, über bzw. unter dem eine strukturierte Lichtquelle angeordnet ist.

Dieser Sensor weist den Nachteil auf, dass die Fotodetektorstruktur und die strukturierte Lichtquelle zwangsläufig nicht den gleichen Abstand zu einem Maßstab aufweisen können, da Leuchtdiode und Fotodetektor übereinander realisiert werden. Dieser unterschiedliche Abstand zum Maßstab verschlechtert wiederum die optischen Eigenschaften des Sensors deutlich.

Aus der EP 543 513 A1 ist bekannt, dass auf einem gemeinsamen Halbleiterschicht aus III/V-Halbleitermaterial, wie beispielsweise Gallium-Arsenid GaAs, sowohl ein strukturierter Fotodetektor als auch eine strukturierte Lichtquelle in Form von mindestens einer Leuchtdiode eines Sensors realisiert werden. Durch diese Realisierung der strukturierten Lichtquelle und des strukturierten Fotodetektors auf einem gemeinsamen Halbleitermaterial kann die Forderung, dass die Sende- und Empfangsstrukturierung möglichst in einer Ebene zu realisieren ist, sehr gut erfüllt werden. Weiterhin erfolgt eine Einfeldabtastung, bei der die Fotoelemente um 90° + k* 360°, mit ganzzahligem k, versetzt sind. Es werden also mehrere Fotoelemente um neunzig Winkelgrad plus ganzzahlige Vielfache von dreihundertsechzig Winkelgrad in Messrichtung zueinander versetzt angeordnet. Dadurch wird die Abtastung besonders störunempfindlich.

Dabei ist von Nachteil, dass nicht beschrieben wird, wie die Herstellung des strukturierten Fotodetektors und der strukturierten Lichtquelle auf einem gemeinsamen Halbleitermaterial aus GaAs erfolgt. Werden aus dem Stand der Technik bekannte Technologien der Halbleiterherstellung angewandt, so ist dieser Herstellungsprozess sehr aufwendig und damit teuer.

Aus der EP 720 005 A2 ist ein optischer Sensor für ein Messsystem bekannt, der ein Licht emittierendes Bauteil, ein Licht empfangendes Bauteil, und mindestens ein optisches Bauteil aufweist, das auf das vom Licht emittierenden Bauteil gesendeten Lichtstrahl einwirkt, bevor dieser das Licht empfangende Bauteil erreicht. Dieser Sensor weist ein Abstandselement auf, welches einen Abstand zwischen dem Licht emittierenden bzw. dem Licht empfangenden Bauteil und dem optischen Bauteil definiert. Dabei ist das Abstandselement derart ausgestaltet, dass es mit einem anderen Bauteil verbunden wird. Dadurch wird erreicht, dass der optisch Sensor auf seiner einen Seite optische Signale sendet und empfängt, weshalb optische Bauteile auf dieser Seite angeordnet werden, und auf seiner anderen Seite Leitungen für elektrische Signale aufweist.

Dabei ist von Nachteil, dass das Licht empfangende Bauteil, das Licht emittierende Bauteil, das mindestens eine optische Bauteil und das Abstandselement alle aus separaten Bauteilen bestehen, die separat gefertigt und zusammengebaut werden müssen. Dies ist bei den geforderten Genauigkeiten für optische Sensoren von Messsystemen sehr teuer. Weiterhin ist der optische Sensor relativ voluminös, da die einzelnen Bauteile auch separat gehandhabt werden müssen.

Aus der DE 197 20 300 A1 ist ein elektronisches Hybridbauelement bekannt, bei dem in Chip on Chip Anordnung ein implantiertes Chip auf einem Trägersubstrat angeordnet wird. Dafür weist das Trägersubstrat mindestens eine Kavität auf, in der sich eine elektrische Isolationsschicht mit einer darüber liegenden Metallschicht befindet. Der in die Kavität implantierte Chip wird mit der Metallschicht kontaktiert, wodurch diese als elektrische Leitung verwendet wird. Ist der implantierte Chip eine Leuchtdiode, kann die Metallisierungsschicht auch dazu benutzt werden, deren Strahlung an den Wänden der Kavität zu reflektieren.

Diese Anordnung weist den Nachteil auf, dass sowohl die Strahlungsrichtung der Leuchtdiode als auch deren elektrischen Kontakte auf einer Seite der Halbleiterschicht angeordnet sind bzw. auf dieser einen Seite emittiert werden.

Aus der DE 196 18 593 A1 ist ein strahlungsempfindliches Detektorelement mit einem aktiven Bereich bekannt, wobei sich der aktive Bereich zwischen zwei aneinandergrenzenden Schichtbereichen einer Schichtanordnung mit unterschiedlichen Ladungsträgern ausbildet und innerhalb dessen eine Umwandlung einfallender elektromagnetischer Strahlung in elektrische Signale erfolgt. Dabei ist die Lage des aktiven Bereichs relativ zu den beiden begrenzenden Oberflächen unter Berücksichtigung der Eindringtiefe der Strahlung derart gewählt, dass mindestens zwei Kontaktelemente zum Anschluss des Detektorelements an eine Auswerteschaltung an einer Oberfläche montierbar sind, die gegenüber der strahlungsempfindlichen Oberfläche liegt, auf die die einfallende Strahlung auftrifft. Bei dem Herstellungsverfahren eines solchen Detektorelements werden die folgenden Verfahrensschritte angewendet. Es wird eine Ätzstopschicht in einem definiert dotierten Halbleiterschicht knapp unterhalb einer begrenzenden ersten Oberfläche erzeugt. Dann folgt ein räumlich selektives Wegätzen des unterhalb der Ätzstopschicht vorhandenen Substrats, bis die Ätzstopschicht eine begrenzende zweite Oberfläche bildet. Anschließend wird ein räumlich begrenzter Schichtbereich oberhalb der Ätzstopschicht, der eine unterschiedliche Dotierung als das Halbleiterschicht aufweist, erzeugt und das Detektorelement wird auf einer Seite, die gegenüberliegend zur zweiten Oberfläche ist, mit mindestens zwei Kontaktelementen kontaktiert.

Dabei ist von Nachteil, dass hier lediglich eine Fotodiode offenbart ist, jedoch kein vollständiger optoelektronischer Sensor.

Aus der DE 198 59 670.7 ist ein Abtastkopf für einen Maßstab mit einer Teilung bekannt, wobei der Abtastkopf im wesentlichen aus einer einzigen Halbleiterschicht besteht, das auf der dem Maßstab zugewandten Seite mehrere strukturierte Fotodetektoren aufweist, das weiterhin ein Sackloch aufweist, welches auf der dem Maßstab zugewandten Seite durch ein Sendegitter begrenzt wird. Das Sendegitter wird dabei in einer auf das Halbleiterschicht aufgebrachten Schicht oder durch eine spezielle Ausgestaltung des Prozesses zum Einbringen des Sacklochs realisiert. Weiterhin ist eine Lichtquelle im Sackloch angeordnet, die in Richtung des Sendegitters abstrahlt.

Dabei ist nachteilig, dass zwischen Sendegitter und Lichtquelle ein relativ großer Abstand besteht. Weiterhin von Nachteil ist, dass die Fotodetektoren auf der dem Maßstab zugewandten Seite kontaktiert werden.

Aus der DE 198 59 669.3 ist ein integrierter optoelektronischer Sensor zur Abtastung einer Teilung bekannt. Der Sensor besteht aus einer einzigen Halbleiterschicht, welches auf der von der Teilung abgewandten Seite mehrere Fotodetektoren aufweist. Im Bereich der Fotodetektoren ist das Halbleitermaterial zumindest partiell entfernt, so dass Licht von der der Teilung zugewandten Seite des Sensors in den Licht detektierenden Bereich der Fotodetektoren eindringen kann. Auf der von der Teilung abgewandten Seite weist der Sensor eine Lichtquelle auf, in deren Bereich die gesamte Dicke der lichtundurchlässigen Komponenten des Sensors durchbrochen ist, so dass die Lichtquelle durch den Sensor hindurchstrahlt. Die Halbleiterschicht ist auf der der Teilung zugewandten Seite mit einem transparenten Trägerkörper verbunden, der mindestens eine weitere Teilung aufweist, durch die die Strahlung der Lichtquelle optisch beeinflusst wird.

Dabei ist von Nachteil, dass die auf dem Trägerkörper aufgebrachte mindestens eine Teilung im Bereich der Fotodetektoren relativ weit von den Fotodetektoren und im Bereich der Lichtquelle relativ weit von der Lichtquelle entfernt ist. Dadurch verschlechtern sich die optischen Eigenschaften. Ein weiterer Nachteil besteht darin, dass im Bereich der Fotodetektoren in einem speziellen Verfahrensschritt bei der Herstellung Halbleitermaterial entfernt werden muss.

Aus JP 06268254 A ist die Integration einer Leuchtdiode in ein poröses Siliziumsubstrat bekannt.

Es stellt sich daher die Aufgabe, einen integrierten optoelektronischen Sensor anzugeben, bei dem der Abstand zwischen den optischen Gittern und den Fotodioden sowie der Lichtquelle möglichst klein ist.

Diese Aufgabe wird durch einen Sensor mit den Merkmalen des Anspruchs 1 gelöst.

Vorteilhafte Ausführungsformen des erfindungsgemäßen Sensors ergeben sich aus den Merkmalen der jeweils abhängigen Ansprüche.

Der erfindungsgemäße Sensor weist den Vorteil auf, dass die Halbleiterschicht, in der die Fotodetektoren realisiert werden, sehr dünn ausgestaltet ist. Dadurch ist der Abstand zwischen den auf dem Träger aufgebrachten Gittern und den Fotodetektoren sowie der Lichtquelle und den Fotodetektoren sehr klein. Dadurch verbessern sich die optischen Eigenschaften des Sensors. Ein weiterer Vorteil besteht darin, dass kein spezieller Verfahrensschritt erforderlich ist, um im Bereich der Fotodetektoren die Dicke der Halbleiterschicht zu verringern. Die Halbleiterschicht ist bereits so dünn, dass sich die detektierenden Bereiche der Fotodetektoren bis an die Grenze zum Träger erstrecken.

Weitere Vorteile sowie Einzelheiten des erfindungsgemäßen Sensors ergeben sich aus der nachfolgenden Beschreibung eines Ausführungsbeispiels anhand der Zeichnungen. Dabei zeigt:
- Figur 1:: einen Schnitt durch einen Dünnschichtsensor mit zugehöriger Maßverkörperung,
- Figur 2:: einen Ausschnitt aus Figur 1 mit einer alternativen Realisierung,
- Figur 3:: einen Ausschnitt aus Figur 1 mit einer alternativen Realisierung,
- Figur 4:: einen Ausschnitt aus Figur 1 mit einer alternativen Realisierung,
- Figur 5:: einen Ausschnitt aus Figur 1 mit einer alternativen Realisierung,
- Figur 6:: einen Ausschnitt aus Figur 1 mit einer alternativen Realisierung,
- Figur 7:: einen Schnitt durch einen weiteren Dünnschichtsensor mit zugehöriger Maßverkörperung, der nicht unter Anspruch 1 fällt,
- Figur 8:: einen schematisierten Verfahrensablauf zur Herstellung eines Dünnschichtsensors,
- Figur 9:: einen weiteren schematisierten Verfahrensablauf zur Herstellung eines Dünnschichtsensors und
- Figur 10:: einen weiteren schematisierten Verfahrensablauf zur Herstellung eines Dünnschichtsensors.

Der Dünnschichtsensor wird im Folgenden anhand von Beispielen erläutert, die ein Längenmesssystem beinhalten. Es besteht jedoch die Möglichkeit, ohne wesentliche Änderungen, den Dünnschichtsensor auch bei einem Winkelmesssystem oder einem zweidimensionalen Messsystem einzusetzen.

Soweit im Folgenden oder in den Figuren Dünnschichtsensoren mit separat aufgesetzten Lichtquellen beschrieben sind, so dienen diese nur als Beispiele zum besseren Verständnis der Erfindung, gemäß der die Lichtquelle in die Halbleiterschicht integriert ist.

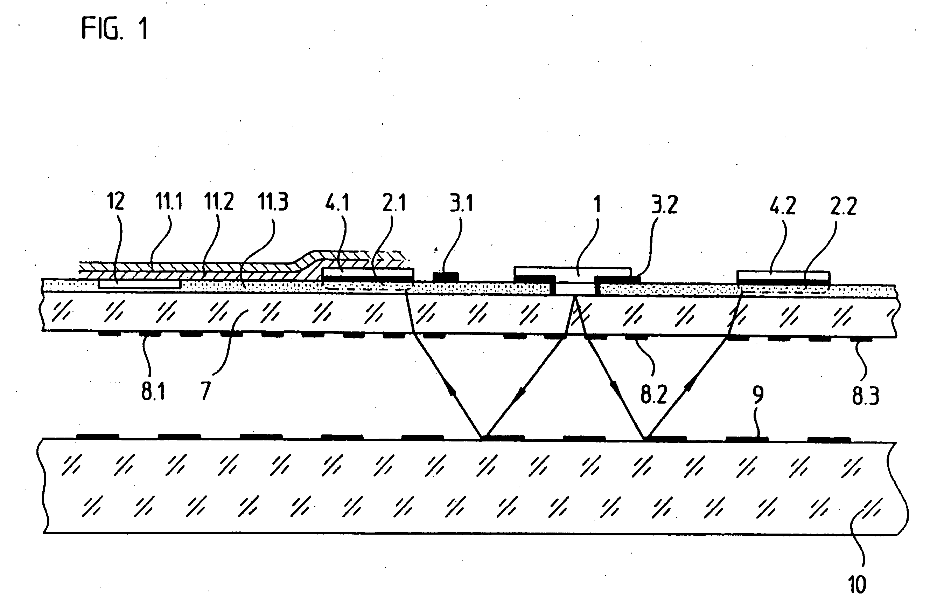

In Figur 1 ist ein optoelektronischer Dünnschichtsensor und ein Maßstab 10 schematisch dargestellt. Der Dünnschichtsensor besteht aus einer dünnen Halbleiterschicht 11.3, vorzugsweise aus Silizium, in die Fotodetektoren 2.1 und 2.2 integriert sind. Auf der vom Maßstab 10 abgewandten Seite der Halbleiterschicht 11.3 sind Passivierungsschichten 11.1 und 11.2, die aus Siliziumoxid und/oder Siliziumnitrid bestehen, angeordnet. Die Fotodioden 2.1 und 2.2 werden unmittelbar in der Halbleiterschicht 11.3 erzeugt, die den Dünnschichtsensor bildet. Die beiden Fotodioden 2.1 und 2.2 symbolisieren lediglich mindestens je eine funktionale Baugruppe, die mehrere Fotodioden oder auch mehrere miteinander verschaltete Gruppen von Fotodioden, beispielsweise für eine Einfeldabtastung, beinhalten können. Weiterhin können die Fotodioden 2.1 und 2.2 strukturiert ausgestaltet sein.

Diese funktionalen Baugruppen Fotodioden 2.1 und 2.2 sind symmetrisch zu einer Strahlenquelle 1 für elektromagnetische Strahlung, insbesondere Licht, angeordnet, die bevorzugt durch eine Leuchtdiode 1 realisiert wird. Dabei kann die Leuchtdiode 1 als separates Bauteil mit der Halbleiterschicht 11.3 verbunden werden, wie in der Figur dargestellt. Alternativ können auch in der Halbleiterschicht 11.3 die Fotodioden 2.1 und 2.2 realisiert werden. Dann wird durch entsprechende Dotierung eine Leuchtdiode 1 in einer Halbleiterschicht 11.3 aus geeignetem Halbleitermaterial, beispielsweise Galliumarsenid, hergestellt.

Die Leuchtdiode 1 kann alternativ auch durch einen organischen oder anorganischen Polymerfilm realisiert werden. Dieser wird dann unmittelbar auf den Träger 7 aufgebracht. Die Kontaktierungen 3.2 für die Leuchtdiode 1 sind dann von der vom Maßstab 10 abgewandten Seite der Halbleiterschicht 11.3 zum Polymerfilm hinzuführen.

Weiterhin sind in der vom Maßstab 10 abgewandten Seite der Halbleiterschicht 11.3 weitere elektrische Baugruppen integriert. Neben elektrischen Leitungen 3.1 und Kontaktflächen 3.2 sind auch komplexe Halbleiterschaltungen 12 in dieser gemeinsamen Halbleiterschicht 11.3 integriert. Dabei handelt es sich bevorzugt um rauscharme Verstärker 12 für die Ausgangssignale der Fotodiodenbaugruppen 2.1 und 2.2 sowie um eine Interpolationsbaugruppe 12 für die Ausgangssignale der rauscharmen Verstärker 12.

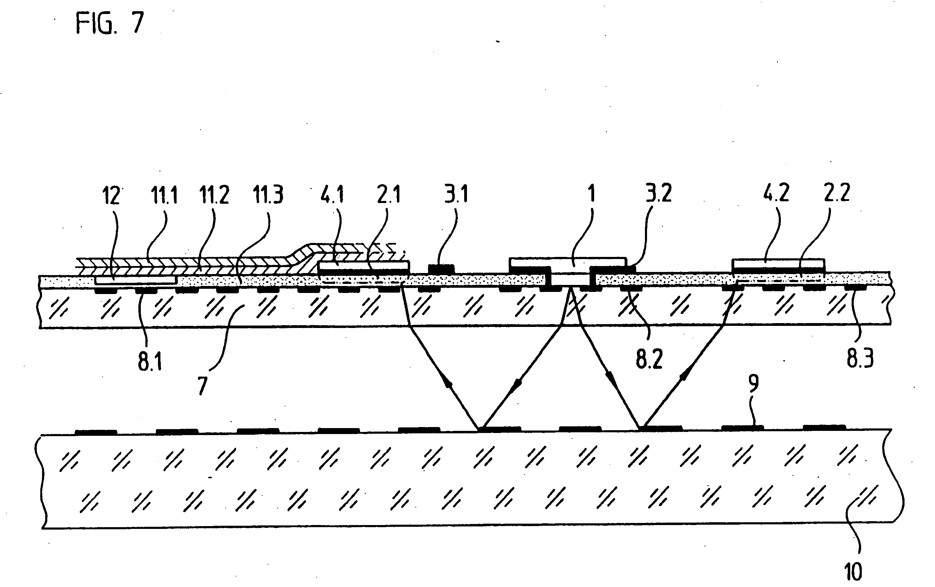

Die Halbleiterschicht 11.3 ist auf der dem Maßstab 10 zugewandten Seite mit einem für die von der Leuchtdiode 1 emittierte Strahlung transparenten Träger 7 verbunden. Diese Verbindung kann durch Kleben, thermisches und/oder anodisches Bonden erreicht werden. Dieser transparente Träger 7 weist eine oder mehrere Teilungen 8.1, 8.2 und 8.3 auf, deren genaue Struktur und Gitterkonstante von dem zu realisierenden Messsystem abhängig ist. Diese Teilungen 8.1, 8.2 und 8.3 werden auf der dem Maßstab zugewandten Seite des Trägers 7 aufgebracht, wie in der Figur 1 gezeigt. Die Teilungen 8.1, 8.2 und 8.3 können dabei auch in die Oberfläche des Trägers 7 eingebracht werden, wenn vorher entsprechende Vertiefungen im Träger 7 für die Teilungen 8.1, 8.2 und 8.3 vorgesehen wurden, wie dies in Figur 7 dargestellt ist.

Der wie in Figur 1 dargestellt aufgebaute optoelektronische Dünnschichtsensor wird gegenüber einem Maßstab 10 angeordnet, der eine Teilung 9 trägt. Sendet die Leuchtdiode 1 ein Lichtbündel in Richtung Maßstab 10, wird dieses Lichtbündel an der Teilung 8.2 erstmals gebeugt, trifft dann auf die Teilung 9 des Maßstabs 10, wird dort wieder gebeugt und an den Teilungen 8.1 und 8.3 erneut gebeugt, bevor das Lichtbündel auf die Fotodioden 2.1 und 2.2 trifft, durch die die Intensität des Lichtbündels erfasst wird. Das Ausgangssignal der Fotodioden 2.1 und 2.2 wird mindestens einem Verstärker 12 und dessen Ausgangssignal mindestens einem Interpolator 12 zugeleitet, wobei all diese Baugruppen in die Halbleiterschicht 11.3 integriert werden können.

Um die elektrische Verdrahtung in einer Ebene ausführen zu können, werden die Fotoelemente 2.1 und 2.2 an der Oberfläche der Halbleiterschicht 11.3 auf der vom Maßstab 10 abgewandten Seite ausgeführt, wie in Figur 1 dargestellt. Die Dicke der aktiven Schicht der Fotodetektoren 2.1 und 2.2 kann je nach Wellenlänge optimiert angepasst werden, z. B. 25 µm Dicke des aktiven Bereichs der Fotodioden 2.1 und 2.2 bei 860 nm Wellenlänge der von der Leuchtdiode 1 abgestrahlten elektromagnetischen Strahlung. Durch diese für die Fotoelemente 2.1 und 2.2 erforderliche Dicke wird die gesamte Dicke der Halbleiterschicht 11.3 bestimmt.

Um eine Erhöhung der Empfindlichkeit der Fotoelemente 2.1 und 2.2 zu erreichen, kann an der Oberfläche der Fotoelemente 2.1 und 2.2, unter der Passivierungsschicht 11.2, ein Reflektor 4.1 und 4.2 aufgebracht werden. Dieser besteht beispielsweise aus Aluminium und wird in Sputtertechnik auf die Fotoelemente 2.1 und 2.2 aufgebracht. Ist dieser Reflektor 4.1 und 4.2 leitend, kann er auch als ein elektrischer Anschluss der Fotodioden 2.1 und 2.2 benutzt werden. Durch den Reflektor 4.1 und 4.2 werden ansonsten austretende Lichtstrahlen nochmals in den aktiven Bereich der Fotodioden 2.1 und 2.2 reflektiert und erhöhen damit den Photostrom. Außerdem ist ein Strukturieren der Kontakte der Fotodioden 2.1 und 2.2 möglich. Dadurch können diese über die gesamte Fläche der Fotodioden 2.1 und 2.2 verteilt werden. Hierfür weisen die Kontakte eine mäanderförmige oder fingerförmige Struktur auf. Dies bewirkt eine örtlich homogene Empfindlichkeit über die gesamte Fläche der Fotoelemente 2.1 und 2.2.

Zusätzlich wird die dem Lichteintritt zugewandte Seite, also die Unterseite des Trägers 7, durch zusätzliche Schichten aus SiO2 und/oder Si₃N₄ entspiegelt. Die Schichtdicke dieser Entspiegelungsschicht wird dabei abhängig von der Wellenlänge der von der Leuchtdiode 1 ausgesendeten Strahlung gewählt.

Die Lichtquelle, beispielsweise eine Leuchtdiode 1, wird auf derselben Ebene integriert und elektrisch kontaktiert wie die Fotodioden 2.1 und 2.2 und die Verstärker- und Interpolationseinheit 12, wie in der Figur 1 dargestellt.

Die Leiterbahnen für die Kontaktierung der Leuchtdiode sind dann entweder vollständig auf dem Träger 7 angeordnet oder sie verlaufen zunächst auf der dem Maßstab 10 abgewandten Seite der Halbleiterschicht 11.3, dann senkrecht dazu entlang der Dicke der Halbleiterschicht bis auf den Träger 10, um die dort angeordnete Leuchtdiode 1 zu kontaktieren.

Eine Alternative zur Realisierung einer Leuchtdiode 1 besteht darin, dass in die Halbleiterschicht 11.3 eine poröse Halbleiterstruktur integriert wird, beispielsweise durch einen anodischen Ätzprozess in Flusssäure. Weiterhin sind entsprechende PN-Übergänge durch Dotierung in den Bereich der porösen Halbleiterstruktur angeordnet, so dass eine Leuchtdiode 1 erzeugt wird.

Dadurch, dass alle elektrischen Anschlüsse für die Leuchtdiode 1, die Fotoelemente 2.1 und 2.2 sowie die Verstärker- und Interpolationseinheit 12 in einer Ebene liegen, lassen sich die elektrischen Verbindungsleitungen 3.1 zu Verarbeitungsbaugruppen 12 für die Ausgangssignale der optoelektronischen Bauteile 2.1, 2.2 einfach ausführen. Eine bevorzugte Technologie ist ein CMOS kompatibler Technologieprozess zur Integration von Verstärker- und Interpolationseinheit 12.

Die gesamte Oberfläche der Kontaktierungsebene kann mit Passivierungsschichten 11.1 und 11.2 abgedeckt werden, beispielsweise aus SiO₂ und Si₃N₄, die wie die Halbleiterschicht 11.3 ebenfalls gemäß einem CVD Prozess (Chemical vapour deposition) aufgebracht werden.

Bevorzugtes Material für die Halbleiterschicht 11.3 ist Silizium mit einer Kristallorientierung (1-0-0). Auch für eine CMOS Integration der Verstärker- und Interpolationseinheit 12 ist Silizium mit dieser Orientierung zu bevorzugen.

Der Träger 7, welcher an der dem Maßstab 10 zugewandten Seite der Halbleiterschicht 11.3 angeordnet ist, trägt die für die optische Wirkung notwendigen Gitterstrukturen 8.1, 8.2 und 8.3, wie in Figur 1 symbolisch dargestellt. Die Gitterstrukturen 8.1, 8.2 und 8.3 können als Phasengitter und/oder als Amplitudengitter in Form von Chromgittern ausgeführt werden. Die Gitterstrukturen 8.1, 8.2 und 8.3 werden auf der der Halbleiterschicht 11.3 abgewandten Seite aufgebracht.

In einer alternativen Ausgestaltung kann der Träger 7 sowohl auf seiner dem Maßstab 10 abgewandten Seite als auch dem Maßstab 10 zugewandten Seite jeweils mindestens eine Gitterstruktur aufweisen. Diese mindestens zwei auf beiden Seiten des Trägers 7 aufgebrachten Gitterstrukturen können dabei sowohl als Phasengitter als auch als Amplitudengitter als auch als eine Kombination aus Phasen- und Amplitudengitter realisiert sein. Die Strukturierung des Phasengitters kann dabei nicht nur parallel zu den Gitterlinien der Teilung 9 auf dem Maßstab 10 angeordnet sein, sondern kann auch senkrecht dazu gewählt werden. Durch eine derartige azimutale Anordnung der Gitterstrukturen werden mehr Bereiche auf der Teilung 9 gleichzeitig abgetastete, wodurch die Verschmutzungsempfindlichkeit verringert wird.

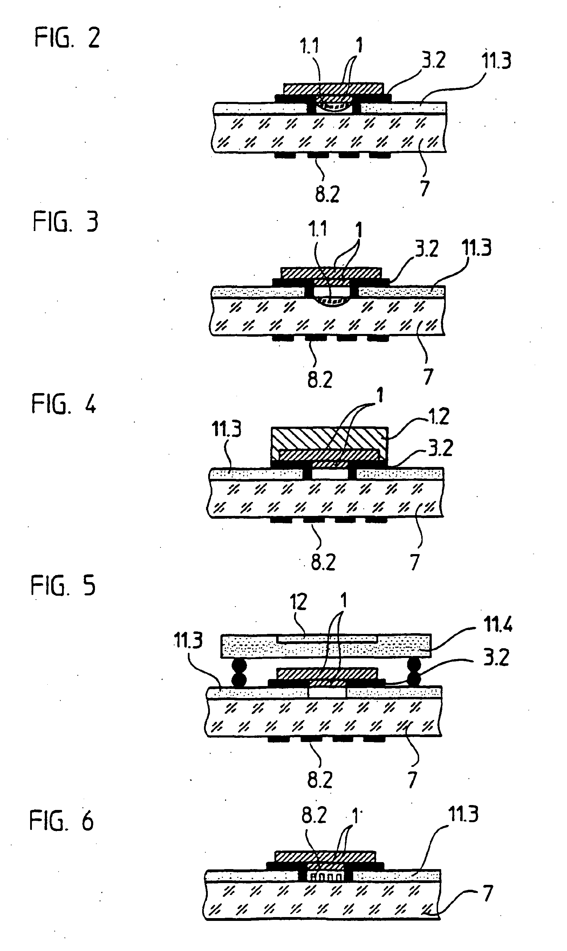

Eine weitere Alternative ist die Einbringung einer optischen Linse 1.1 in den Träger 7 unterhalb der Abstrahlungsebene der Leuchtdiode 1, wie in Figur 3 dargestellt. Die Linse 1.1 kann im Träger 7 auf der dem Maßstab 10 zu- und/oder abgewandten Seite des Trägers 7 aufgebracht werden. Technologisch wird eine solche Linse 1.1 beispielsweise durch Elektronenlithografie in PMMA-Resist erzeugt. Die Wölbung der Linse 1.1 im Resist wird durch unterschiedliche Bestrahlungsdosen im Resist erzeugt, die Resiststruktur wird dann durch Plasmaätzen in den Träger 7 übertragen. Bei dieser Technologie ist es auch möglich, der Linse 1.1 selbst eine Struktur, also z. B. ein Phasengitter 8.2 aufzuprägen. Der Verfahrensschritt zum Einbringen einer optischen Linse 1.1 in den Träger 7 kann auch bereits vor dem Abscheiden der Halbleiterschicht 11.3 erfolgen.

Der Träger 7 kann vorteilhaft aus dem Material Pyrex bestehen, welches denselben Längenausdehnungskoeffizient wie Silizium aufweist. Dies vermindert Spannungen, erhöht die mechanische Stabilität im Silizium und vermeidet damit Versetzungslinien im Silizium, die zu elektrischen Störstellen führen können. Weitere für den Träger 7 geeignete Materialien sind Saphir und geeignete Borsilikatgläser.

Das Messsystem, bei dem der erfindungsgemäße Sensor benutzt wird, kann sowohl ein eindimensionales Messsystem, wie ein Längen- oder Winkelmesssysteme, als auch ein zweidimensionales Messsystem sein, wie ein Kreuzgittermesssystem, das als Maßstab ein Kreuzlinien- oder Schachbrettgitter aufweist. Das dafür erforderliche Abtastsystem weist entweder zwei erfindungsgemäße, vorteilhaft orthogonal zueinander ausgerichtete Sensoren auf. Alternativ können auch in einen Sensor zwei Gruppen von Fotoelementen mit eindimensionaler Strukturierung integriert werden, deren Ausrichtung den Messrichtungen entsprechen oder die orthogonal zueinander stehen. Das Sendegitter wird dann als zweidimensionales Gitter, beispielsweise Kreuzlinien- oder Schachbrettgitter, ausgestaltet und ist dadurch nur einfach erforderlich.

Um einen kompakteren Aufbau des gesamten Sensors zu erreichen, können weitere elektronische Schaltungen 12 auch in einer separaten Halbleiterschicht 11.4 integriert werden, die räumlich über der Halbleiterschicht 11.3 mit den optoelektronischen Baugruppen angeordnet wird, wie dies in Figur 5 dargestellt wird. Da die elektrischen Kontakte bereits ausschließlich auf der Oberseite der Halbleiterschicht 11.3 mit den optoelektronischen Baugruppen angeordnet sind, ist eine Kontaktierung mit der darüber angeordneten Halbleiterschicht 11.4 in Chip on Chip Technologie sehr einfach möglich. Dadurch können die Längen der Verbindungsleitungen zwischen den optoelektronischen und den elektronischen Baugruppen wesentlich verkürzt werden, was zu einer verbesserten Störunempfindlichkeit führt und eine schnellere Signalverarbeitung aufgrund einer höheren Taktrate ermöglicht.

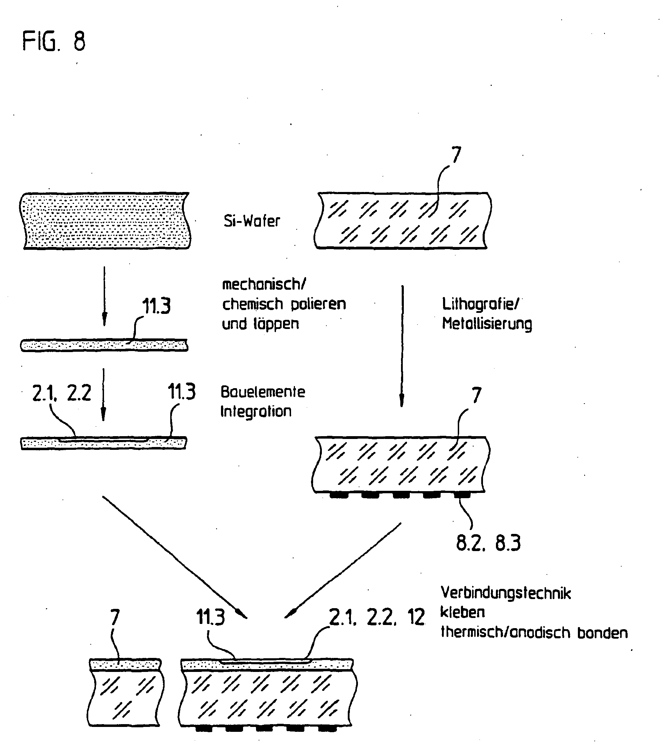

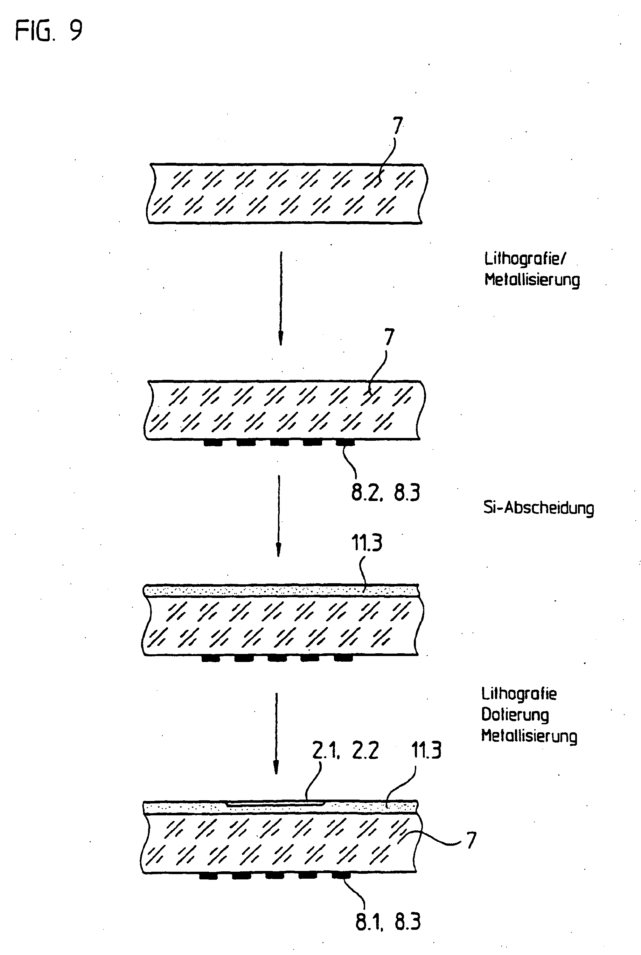

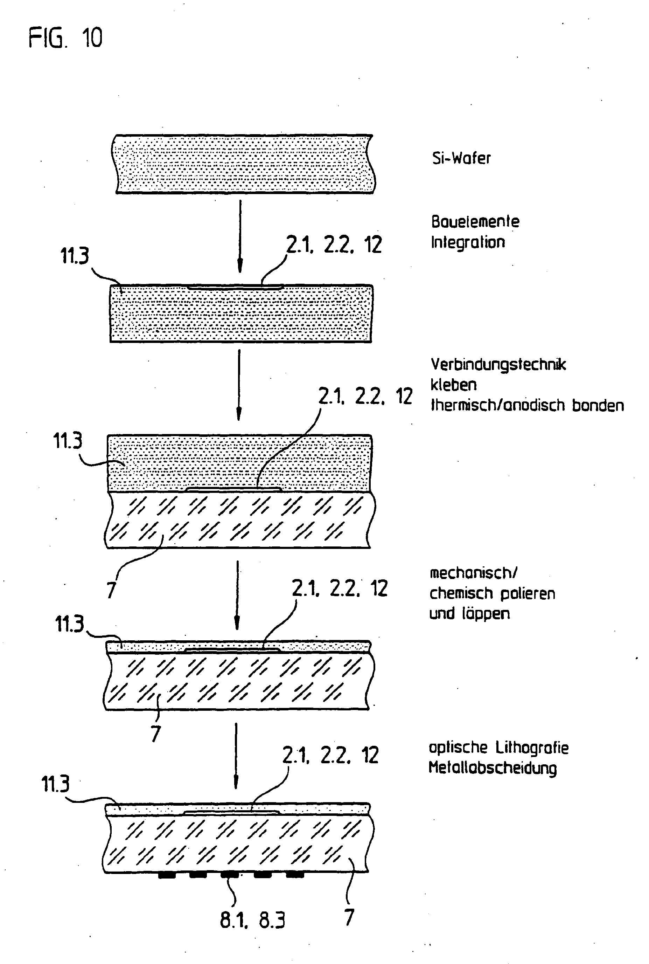

Im folgenden sollen die einzelnen Verfahrensschritte zur Herstellung eines Dünnschichtsensors gemäß den Figuren 8, 9 und 10, die drei unterschiedliche Vorgehensweisen darstellen und die teilweise bereits erwähnt wurden, näher beschrieben werden.

Im wesentlichen gliedert sich das Herstellungsverfahren in die drei Bereiche: Bearbeitung des Trägers 7, Bearbeitung der Halbleiterschicht 11.3 und Verbindung der beiden Teile. Prinzipiell können Träger 7 und Halbleiterschicht 11.3 entweder getrennt voneinander oder wenn diese bereits miteinander verbunden sind bearbeitet werden.

Somit besteht die Möglichkeit, dass zunächst der Träger 7 bearbeitet wird und anschließend entweder die bereits fertig gestellte Halbleiterschicht 11.3 aufgebracht wird oder die Halbleiterschicht nach dem Verbinden mit dem Träger 7 erst noch bearbeitet wird. Alternativ dazu kann auch zuerst die Halbleiterschicht 11.3, eventuell bereits fertig bearbeitet, auf den Träger 7 aufgebracht werden und dann der Träger 7 - und gegebenenfalls die Halbleiterschicht 11.3 - fertig gestellt werden. Die Reihenfolge der Bearbeitung von Träger 7, Halbleiterschicht 11.3 und deren Verbindung miteinander kann im wesentlichen frei gewählt werden, wodurch sich mehrere alternative Verfahrensabläufe ergeben. Es besteht lediglich die Einschränkung, dass nach dem Verbinden der Halbleiterschicht 11.3 mit der vom Maßstab 10 abgewandten Seite des Trägers 7 auf dieser vom Maßstab 10 abgewandten Seite des Trägers 7 keine Gitterstrukturen 8.1, 8.2 und 8.3 mehr aufgebracht werden können.

Bei einem Verfahren zur Herstellung der Halbleiterschicht 11.3 wird auf der vom Maßstab 10 abgewandten Seite des Trägers 7 Halbleitermaterial, bevorzugt Silizium, in der gewünschten Dicke aufgetragen. Dies kann in einem CVD-Prozess oder anderen aus dem Stand der Technik bekannten Verfahren erfolgen. Dabei wird eine kristalline, polykristalline, amorphe, poröse, mikro- oder nanokristalline Halbleiterschicht 11.3 abgeschieden. Alternativ dazu kann an Stelle des Trägers 7 die Halbleiterschicht 11.3 zunächst auf einem Wafer bearbeitet und erst später mit dem Träger 7 verbunden werden.

In einer weiteren Alternative kann die Halbleiterschicht 11.3 auch aufgesputtert und anschließend mit einem Laser geschmolzen werden, so dass sich nach Erkalten des Halbleitermaterials die benötigte Halbleiterschicht 11.3 ausbildet.

Gemäß einer weiteren Alternative kann Halbleitermaterial durch mechanische Bearbeitung bis zu einer Dicke von ca. 30 µm reduziert und anschließend chemisch geläppt werden. Diese dünne Halbleiterschicht 11.3 wird danach mit dem Träger 7 verbunden, beispielsweise durch Bondverfahren.

In einem zweiten Schritt werden die Fotodioden 2.1 und 2.2 durch entsprechende Dotierung der Bereiche, in denen die Fotodetektoren angeordnet sein sollen, erzeugt. In diesem Schritt kann auch die Erzeugung der weiteren Baugruppen wie Verstärker- und Interpolatoreinheit 12 erfolgen.

In einem dritten Schritt werden Leiterbahnen 3.1 und Kontaktierungen 3.2, ebenso wie metallische Beschichtungen 4.1 und 4.2 der Rückseiten der Fotodioden 2.1 und 2.2 aufgebracht. Dies erfolgt durch Aufbringen einer Metallisierungsschicht aus Aluminium-Titanoxid, die in bekannten fotochemischen Prozessen entsprechend strukturiert wird, auf die Halbleiterschicht 11.3.

Bei dem Verfahren zur Herstellung des Trägers 7 besteht die Möglichkeit, eine Linse 1.1 in den Träger 7 zu integrieren, die das Licht der Leuchtdiode 1 kollimiert. Dafür wird in einem PMMA-Resist eine Vorlage für die Linse mittels Elektronenstrahllithographie geformt. Die Dosis während des Belichtens mit Elektronen wird dabei so verändert, dass sich nach dem Entwicklungsprozess die Form einer optischen Linse 1.1 ergibt. Diese wird, beispielsweise mittels Plasmaätzprozess, ins Material des Trägers 7 übertragen.

Anschließend werden die Gitterstrukturen 8.1, 8.2 und 8.3 auf den Träger 7 aufgebracht. Phasengitter können auf die gleiche Weise wie die soeben für eine Linse beschrieben auf dem Träger 7 erzeugt werden. Amplitudengitter werden nach bekannten Verfahren, beispielsweise als Chromgitter, auf den Träger 7 aufgebracht.

Die Verbindung von Träger 7 und Halbleiterschicht 11.3 kann gemäß den Figuren 8, 9 und 10 zu einem beliebigen Zeitpunkt erfolgen. Vorteilhaft ist die Verbindung durchzuführen, wenn Träger 7 und Halbleiterschicht 11.3 fertig bearbeitet sind, da dann Träger 7 und Halbleiterschicht 11.3 getrennt voneinander bearbeitet werden können, wie in Figur 8 dargestellt. Alternativ dazu kann es vorteilhaft sein, die Halbleiterschicht 11.3 direkt auf dem Träger 7, der sich in einem beliebigen Bearbeitungsstadium befindet, abzuscheiden.

Alternativ besteht die Möglichkeit, nur an den Stellen Halbleitermaterial auf dem Träger 7 abzuscheiden, an denen auch Halbleiterbaugruppen des Sensors vorgesehen sind. Dies wird dadurch erreicht, dass das Halbleitermaterial, wie bereits beschrieben, als Halbleiterschicht 11.3 auf der gesamten vom Maßstab 10 abgewandten Seite des Trägers 7 angeordnet wird und anschließend das nicht benötigte Halbleitermaterial in lithografischen Prozessen wieder entfernt wird. Alternativ dazu kann Halbleitermaterial auch selektiv nur dort auf dem Träger 7 aufgebracht werden, wo auch Halbleiterbaugruppen vorgesehen sind.

Der folgende Anspruch 1 enthält einen nicht in den ursprünglich eingereichten Unterlagen offenbarten Disclaimer, um Neuheit gegenüber der EP 1014034 A2 herzustellen. In dieser nicht vorveröffentlichten Anmeldung ist zwischen dem Träger und der Halbleiterschicht ein Halbleitersubstrat offenbart.

## Patentansprüche

1. Messsystem, mit einem Maßstab (10), einem dem Maßstab (10) gegenüberliegenden transparenten Träger (7) mit mindestens einer Gitterstruktur (8.1, 8.2, 8.3), sowie einer auf der dem Maßstab (10) abgewandten Seite des Trägers (7) aufgebrachten und als Dünnschicht ausgebildeten Halbleiterschicht (11.3), wobei in der Halbleiterschicht (11.3) mindestens eine Lichtquelle (1), mindestens eine elektronische Schaltung (12) und mindestens ein Photodetektor (2.1, 2.2) integriert sind, wobei auf der dem Maßstab (10) abgewandten Seite des Photodetektors (2.1, 2,2) eine für die Strahlung der Lichtquelle (1) reflektierende Schicht (4.1, 4.2) angeordnet ist, und auf der dem Maßstab (10) zugewandten Seite des Trägers (7), wo vom Maßstab (10) gebeugtes Licht der Lichtquelle (1) auftrifft, eine Entspiegelungsschicht vorgesehen ist, die durch die Gitterstrukturen (8.1, 8.2, 8.3), strukturiert ist, und wobei die Dicke der Halbleiterschicht (11.3) im wesentlichen der Dicke des detektierenden Bereichs des mindestens einen Photodetektors (2.1, 2.2) entspricht, wobei zwischen dem Träger (7) und der als Dünnschicht ausgebildeten Halbleiterschicht (11.3) kein die Halbleiterschicht (11.3) tragendes Halbleitersubstrat angeordnet ist.

2. Messsystem nach Anspruch 1, wobei die elektronische Schaltung (12) einen Verstärker und eine Interpolationsbaugruppe umfasst.

3. Messsystem nach Anspruch 1 oder 2, wobei die Halbleiterschicht (11.3) aus Silizium besteht.

4. Messsystem nach einem der vorhergehenden Ansprüche, wobei Photodetektoren (2.1, 2.2) symmetrisch zur Lichtquelle (1) angeordnet sind.

5. Messsystem nach einem der vorhergehenden Ansprüche, wobei die Lichtquelle (1) divergent abstrahlt.

6. Messsystem nach einem der vorhergehenden Ansprüche, wobei die Lichtquelle (1) durch einen pn-Übergang in einem porösen Halbleitersubstrat lokal realisiert wird.

7. Messsystem nach einem der vorhergehenden Ansprüche, wobei auf der dem Maßstab (10) abgewandten Seite der Halbleiterschicht (11.3) eine Passivierungsschicht (11.1, 11.2) aus Siliziumoxid und/oder Siliziumnitrid vorgesehen ist.

8. Messsystem nach einem der vorhergehenden Ansprüche, wobei der Träger (7) einen ähnlichen Temperaturausdehnungskoeffizienten wie die Halbleiterschicht (11.3) aufweist.

9. Messsystem nach einem der vorhergehenden Ansprüche, wobei der Träger (7) aus einem Borsilikatglas oder Saphir besteht.

10. Messsystem nach einem der vorhergehenden Ansprüche, wobei elektrische Leitungen (3.1) und Kontaktierungen (3.2) auf der vom Maßstab (10) abgewandten Seite der Halbleiterschicht (11.3) angeordnet sind.

11. Messsystem nach einem der vorhergehenden Ansprüche, wobei als Gitterstruktur (8.1, 8.2, 8.3) ein Amplitudengitter und/oder ein Phasengitter verwendet wird.

## Claims

1. A measuring system comprising a scale (10), a transparent support (7), which is located opposite the scale (10) and which comprises at least one grating structure (8.1, 8.2, 8.3) as well as a semiconductor layer (11.3), which is applied to the side of the support (7) facing away from the scale (10) and which is embodied as thin layer, wherein at least one light source (1), at least one electronic circuit (12) and at least one photodetector (2.1, 2.2) are integrated in the semiconductor layer (11.3), wherein a reflecting layer (4.1, 4.2) for the irradiation of the light source (1) is arranged on the side of the photodetector (2.1, 2.2) facing away from the scale (10) and provision is made on the side of the support (7) facing the scale (10), where light of the light source (1) diffracted by the scale (10) incides, for an antireflection layer, which is structured by the grating structures (8.1, 8.2, 8.3) and wherein the thickness of the semiconductor layer (11.3) corresponds substantially to the thickness of the detected area of the at least one photodetector (2.1, 2.2), wherein no semiconductor substrate supporting the semiconductor layer (11.3) is arranged between the support (7) and the semiconductor layer (11.3), which is embodied as thin layer.

2. The measuring system according to claim 1, wherein the electronic circuit (12) comprises an amplifier and an interpolation component assembly.

3. The measuring system according to claim 1 or 2, wherein the semiconductor layer (11.3) consists of silicon.

4. The measuring system according to one of the preceding claims, wherein photodetectors (2.1, 2.2) are arranged symmetrically to the light source (1).

5. The measuring system according to one of the preceding claims, wherein the light source (1) emits in a divergent manner.

6. The measuring system according to one of the preceding claims, wherein the light source (1) is realized locally by means of a pn junction in porous semiconductor substrate.

7. The measuring system according to one of the preceding claims, wherein provision is made on the side of the semiconductor layer (11.3) facing away from the scale (10) for a passivation layer (11.1, 11.2) of silicon oxide and/or silicon nitride.

8. The measuring system according to one of the preceding claims, wherein the support (7) encompasses a similar temperature expansion coefficient as the semiconductor layer (11.3).

9. The measuring system according to one of the preceding claims, wherein the support (7) consists of a borosilicate glass or sapphire.

10. The measuring system according to one of the preceding claims, wherein electric lines (3.1) and contactings (3.2) are arranged on the side of the semiconductor layer (11.3) facing away from the scale (10).

11. The measuring system according to one of the preceding claims, wherein an amplitude grating and/or a phase grating are used as grating structure (8.1, 8.2, 8.3).

## Revendications

1. Système de mesure avec une échelle graduée (10), un support (7) transparent situé en face de l'échelle graduée (10), avec au moins une structure de grille (8.1, 8.2, 8.3), ainsi qu'une couche de semi-conducteur (11.3) formée en couche fine et appliquée d'un côté du support (7) détourné de l'échelle graduée (10), dans lequel au moins une source de lumière (1), au moins un circuit électronique (12) et au moins un photo-détecteur (2.1, 2.2) sont intégrés à la couche de semi-conducteur (11.3), dans lequel une couche réfléchissante (4.1, 4.2) pour le rayonnement de la source de lumière (1) est disposée du côté du photo-détecteur (2.1, 2.2) qui est détourné de l'échelle graduée (10), et dans lequel une couche anti-réfléchissante, structurée par les structures de grille (8.1, 8.2, 8.3) est prévue du côté du support (7) qui est tourné vers l'échelle graduée (10), à l'endroit où apparaît la lumière de la source de lumière (1) fléchie par l'échelle graduée (10), et dans lequel l'épaisseur de la couche de semi-conducteur (11.3) correspond quasiment à l'épaisseur de la région de détection de l'au moins un photo-détecteur (2.1, 2.2), aucun substrat de semi-conducteur portant la couche de semi-conducteur (11.3) n'étant prévu entre le support (7) et la couche de semi-conducteur (11.3) conçue en couche fine.

2. Système de mesure selon la revendication 1, dans lequel le circuit électronique (12) comprend un amplificateur et un ensemble d'interpolation.

3. Système de mesure selon la revendication 1 ou 2, dans lequel la couche de semi-conducteur (11.3) est constituée de silicium.

4. Système de mesure selon l'une des revendications précédentes, dans lequel des photo-détecteurs (2.1, 2.2) sont disposés de façon symétrique par rapport à la source de lumière (1).

5. Système de mesure selon l'une des revendications précédentes, dans lequel la source de lumière (1) diffuse la lumière de façon divergente.

6. Système de mesure selon l'une des revendications précédentes, dans lequel la source de lumière (1) est réalisée localement, à l'aide d'une transition pn dans un substrat de semi-conducteur poreux.

7. Système de mesure selon l'une des revendications précédentes, dans lequel une couche de passivation (11.1, 11.2) en oxyde de silicium et/ou nitrure de silicium est prévue du côté de la couche de semi-conducteur (11.3) qui est détournée de l'échelle graduée (10).

8. Système de mesure selon l'une des revendications précédentes, dans lequel le support (7) présente un coefficient de dilatation thermique semblable à celui de la couche de semi-conducteur (11.3).

9. Système de mesure selon l'une des revendications précédentes, dans lequel le support (7) est constitué d'un verre borosilicaté ou de saphir.

10. Système de mesure selon l'une des revendications précédentes, dans lequel des lignes électriques (3.1) et des connexions (3.2) sont prévues du côté de la couche de semi-conducteur (11.3) qui est détournée de l'échelle graduée (10).

11. Système de mesure selon l'une des revendications précédentes, dans lequel une grille d'amplitude et/ou une grille de phase est utilisée comme structure de grille (8.1, 8.2, 8.3).
